# EUROPEAN PATENT SPECIFICATION

(11) **EP 0 255 263 B1**
(45) Date of publication and mention of the grant of the patent: **04.01.1995**
(21) Application number: 87306303.6
(22) Date of filing: 16.07.1987
(51) Int. Cl.: H03H 9/02, H03H 9/145

(54) **Transducer**
Wandler
Transducteur

(30) Priority: 29.07.1986 US 891237
(43) Date of publication of application: 03.02.1988
(73) Proprietor: R F MONOLITHICS, INC., Dallas, TX 75234 (US)
(72) Inventor: Wright, Peter V., Dallas Texas 75240 (US)
(74) Representative: Jackson, Peter Arthur

(56) References cited:
- EP-A- 0 186 410
- GB-A- 2 168 869
- US-A- 4 353 046
- PATENT ABSTRACTS OF JAPAN, vol. 3, no. 60 (E-112), 23rd May 1979, page 115 E 112;& JP-A-54 38 741
- ELECTRONICS LETTERS, vol. 10, no. 19, 19th September 1974, pages 395-396; H. ENGAN: "High-frequency operation of surface-acoustic-wave multielectrode transducers"
- SOVIET TECHNICAL PHYSICS LETTERS, vol. 11, no. 1, January 1985, pages 24-25, American Institute of Physics, Woodbury, New York, US; V.I. ANISIMKIN et al.: "Shear-surface-wave resonator"
- IEEE TRANSACTIONS ON CONSUMER ELECTRONICS, vol. CE-24, no. 1, February 1978, pages 96-104, IEEE, New York, US; W.R. SHREVE et al.: "Surface acoustic wave devices for use in a high performance television tuner"

## Description

Surface acoustic wave devices known as SAW devices have many uses in the UHF and VHF frequency ranges. SAW devices have been especially useful as impedance elements, resonators, and band pass filters in these frequency ranges. Typical SAW devices have a substrate with at least a surface layer of piezo-electric material and surface acoustic wave transducers in interdigitated form disposed on the piezo-electric surface. The transducers convert an electrical signal to surface acoustic waves propagating on the piezo-electric surface. Several problems are associated with prior art λ/4 surface acoustic wave transducers. One of the problems occurs because the transducer electrodes cause internal reflections which distort the transducer output and the shape of the input conductance. Another problem occurs when the transducer is used in filter applications. Triple transit distortion is caused by regeneration reflections in the transducers.

The first problem, distortion caused by internal reflections, is solved in the prior art by the use of structures having 3 or 4 electrodes per wavelength to cancel the internal reflections and provide a symmetrical input conductance wave shape. However, the increased number of electrodes per wavelength limits the frequency of operation of the structure due to photolithographic constraints.

In order to eliminate triple transit distortion, three-phase and single-phase devices are used to form unidirectional transducers. Again the size of the electrodes becomes a limiting factor in the construction of the device and thereby limits the frequency of operation of the device.

According to the central concept of the present invention, a substantially reflectionless surface acoustic wave transducer comprises a substrate having at least a surface layer of piezo-electric material on which surface acoustic waves may be propagated, first and second opposed conductive transducer pads on the substrate; and a plurality of groups of N interdigitated λ/4 electrodes (where N is an integer ≧2) extending from the opposed conductive pads to form an elongate transducer, characterised in that all adjacent ones of the electrodes in each of the groups extend from different ones of the two pads, adjacent electrodes within each group having a spacing of λ/4 and the spaces between adjacent groups having a spacing of λ/2, or a multiple thereof, such that adjacent groups cancel reflections from one another.

The present invention thus provides a simple single level interdigitated SAW transducer having λ/4 electrodes in which reflections are cancelled and therefore allow a structure to be built at twice the frequency of those presently available. The device has an undistorted output and a symmetric input conductance, can be placed on standard crystal cuts and can be made into a single-phase unidirectional transducer as a two level structure in a simple manner. Further the single-phase transducer can be made with a flat input susceptance and symmetric input conductance for use as impedance elements. All the electrodes in the transducer are λ/4 and the gaps between electrodes in the groups are λ/4 so that the electrodes of the transducer are on a fixed grid for relatively easy construction. Electrode reflections in the transducer are completely cancelled by destructive interference on a local basis. The groups can consist of any number of electrodes, N, where N is equal or greater than two. Thus electrode groups may consist of two, three, four or more electrodes per group.

Starting from the central concept of a substantially reflectionless transducer resulting from the particular new electrode arrangement, it is possible to provide a weakly unidirectional transducer by one of two simple modifications. According to the first, alternate ones of the groups of electrodes are mass loaded to provide weak unidirectional wave propagation. If the mass loading of the alternate groups is reversed, the sense of the unidirectionality also changes.

According to the second modification, the groups of electrodes consist of alternate groups of N and N+1 interdigitated electrodes (where N is an integer ≧2), such that the (N+1)st electrode(s) provide(s) weak unidirectional wave propagation.

The frequency response of a transducer with two electrodes per group includes group type responses which are 40% above and below the pass band. While this is a disadvantage, the responses are sufficiently far removed from the pass band for most filtering applications. Also, as the number of electrodes per group increases, the group type responses move closer to the pass band. This allows coupled resonators and filters to be constructed with one transducer having a first number of electrodes n per grouping and a second transducer to be constructed of an electrode grouping having a different number of electrodes thereby allowing good communication between the transducers in the pass band but poor communication between the transducers out of the pass band.

The invention thus enables the formation of a surface acoustic wave resonator filter of the type having input and output spaced aligned transducers and a grating structure interposed between the input and output transducers and being resonant at the same frequency as the input and output transducers, wherein a first one of the transducers is in accordance with the first modification with N=2, and the second one of the transducers is in accordance with the first modification, with N=3, the mass loading of alternate ones of the electrode groups of the first transducer causing substantial unidirectional wave propagation in the direction of the second transducer; and the mass loading of alternate ones of the electrode groups of the second transducer causing substantial unidirectional wave propagation in the direction of the first transducer, whereby a filter is obtained with suppression of out-of-band responses.

The invention also enables the formation of a surface acoustic wave resonator of the type having input and output spaced aligned transducers; wherein a first one of the transducers is in accordance with in the first modification, with N=2, and the second one of the transducers is in accordance with the first modification, with N=3, the mass loading of alternate ones of the electrode groups of the first transducer causing substantial unidrectional wave propagation in the direction of the second transducer, and the mass loading alternate ones of the electrode groups of the second transducer causing substantial unidirectional wave propagation in the direction of the first transducer, whereby a resonator is obtained with suppression of out-of-band responses.

The invention will be described by way of example in conjunction with the accompanying drawings, in which:-
Figure 1 is a diagrammatic representation of a prior art surface acoustic wave transducer having interdigitated λ/4 electrodes which create internal reflections in the transducer;
Figure 2 is a diagrammatic representation of a prior art surface acoustic wave transducer being constructed with split finger electrodes in order to eliminate internal reflections and thereby having electrode widths of λ/8;
Figure 3 is a diagrammatic representation of the novel unweighted surface acoustic wave transducer of the present invention which has single level λ/4 interdigitated electrodes but which completely cancels electrode reflections within the transducer;
Figure 4 is a graph of the broad band frequency response for the transducer of Figure 3 indicating out of band spurious "group type" responses;
Figure 5 is a graph illustrating the acoustic reflection coefficient on the transducer of Figure 3 under short circuit conditions and indicating the extremely small reflection coefficient across the pass band;
Figure 6 is a diagrammatic representation of the novel unweighted transducer of the present invention having three electrodes per group;
Figure 7 is a graph showing the frequency response of the novel transducer of Figure 6 indicating that group type responses for this transducer are closer in to the pass band than with the transducer of Figure 3;
Figure 8 is a diagrammatic representation of a filter formed utilizing the transducers of the present invention;
Figure 9 is a diagrammatic representation of a two-port resonator filter formed with first and second transducers of the present invention which have different groupings of interdigitated electrodes to suppress out-of-band group responses;
Figure 10 is a diagrammatic representation of a novel transducer of the present invention which is made unidirectional by mass loading alternate groups of the interdigitated electrodes;
Figure 11 is a graph of the frequency response on the forward acoustic port of the unidirectional transducer illustrated in Figure 10;
Figure 12 is a graph of the frequency response of the reverse acoustic port of the novel transducer illustrated in Figure 10 showing that the centre frequency transmission response from the reverse port is less than the transmission response on the forward port thus indicating substantial unidirectionality of the device; and,
Figure 13 is an alternate version of the unweighted device in which an additional interdigitated electrode has been added in alternate ones of the groups of N electrodes to form a weakly unidirectional transducer.

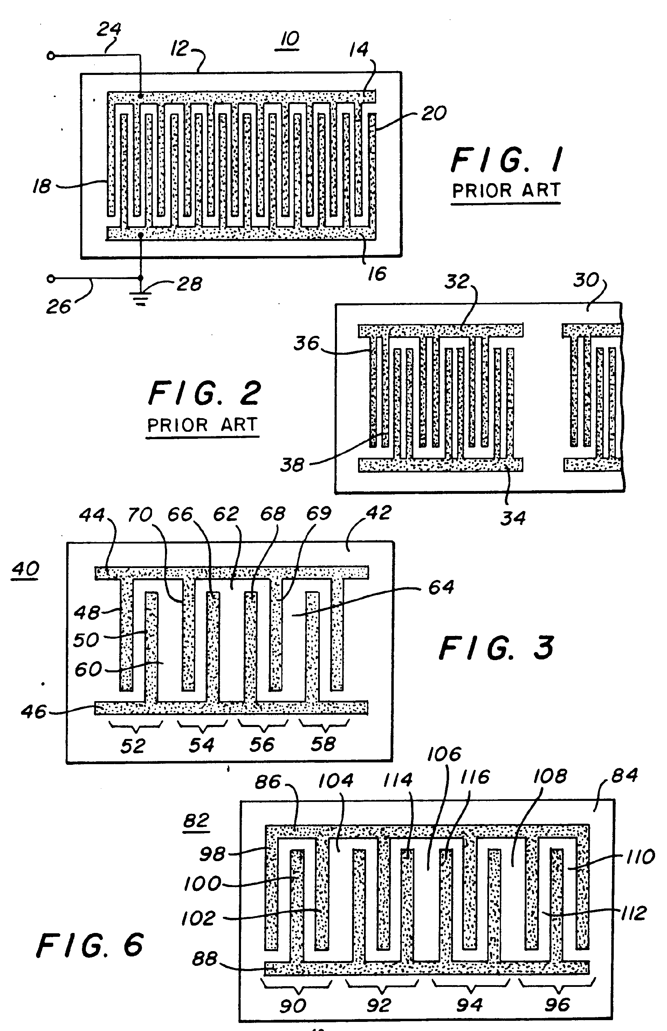

Figure 1 illustrates a typical prior art transducer element which can be used to form various surface acoustic wave devices. The transducer element 10 comprises substrate 12 having at least a surface layer of piezo-electric material thereon through which acoustic waves may be propagated. Opposed conductive transducer pads 14 and 16 are defined on the substrate 12 in a well known manner and include a plurality of interdigitated surface acoustic wave electrodes 18 and 20 extending from the opposed pads 14 and 16 respectively and forming an elongated transducer. Leads 24 and 26 are connected to conductive transducer pads 14 and 16 respectively as input and output terminals. One of the transducer pads, such as conductive pad 16, may be grounded as at 28. The number of interdigitated electrodes 18 and 20 may, of course, vary but a large number of them are used under normal conditions to form transducer 10. Only a few of the electrodes 18 and 20 are shown in Figure 1 for purposes of simplicity of the drawings. The electrodes 18 and 20 have a width of λ/4 and are spaced by λ/4 and the device has two electrodes per wave length.

The prior art transducer of Figure 1 tends to reflect acoustic signals between electrodes. These internal reflections distort the response of the transducer.

Because of these internal reflections, the transducer output is distorted and the shape of its input conductance is distorted. Thus, the use of the device is limited because of these distortions. In order to overcome the distortions, the prior art transducers are formed with three of four electrodes per wavelength. By constructing the transducer in this manner, the reflections are cancelled thus allowing a transducer to be constructed with an undistorted output and an undistorted input conductance. However, another problem is created since the greater the number of electrodes per wavelength, the smaller in size the electrodes and, thus, frequency of operation of the device is limited.

Further, if the structure of Figure l is used in a filter application, triple transit distortion occurs and the transducers must be severely mismatched to reduce the distortion resulting in a high insertion loss. To eliminate triple transit distortion, the prior art utilizes unidirectional transducers formed as single-phase or three-phase devices as is well known.

Such a prior art single-phase unidirectional transducer can be seen in Figure 2. It is a split electrode transducer constructed with a piezo-electric substrate 30 on which transducer pads 32 and 34 are disposed and which have electrodes 36 and 38 forming an electrode pair extending in interdigitated form from each of the conductor pads 32 and 34. Such a conventional split finger electrode transducer is commonly considered to have no net internal reflections as is well known in the art because the reflected waves from one electrode 36 and its nearest neighbour 38 are 180° out of phase and cancel because of the λ/8 width of the electrodes and the spaces between them. The finger and gap widths of a transducer as shown in Figure 2 with split finger construction are one eighth of the operating acoustic wave length thus limiting the frequency range of the device by photolithographic constraints to a maximum frequency of operation of around 600 MHz when compared to a 1200 MHz range for the simplest form of SAW transducer shown in Figure 1 and described earlier.

Thus the structure with split finger construction does eliminate internal reflections but has frequency constraint problems. The device can be made unidirectional by mass loading alternate electrodes as set forth in U.S. Patent No. 4,353,046 thereby enabling the device to be used in applications such as filters where triple transit distortion must be eliminated.

Figure 3 is a diagrammatic representation of the novel unweighted surface acoustic wave transducer of the present invention which is substantially reflectionless and which utilizes quarter wave length construction of the electrodes and which can easily be made unidirectional. The transducer 40 as shown in Figure 3 comprises a substrate 42 having at least a layer of piezo-electric material on which acoustic waves may be propagated. First and second opposed conductive transducer pads 44 and 46 are defined on the substrate 42. A plurality of groups 52, 54, 56 and 58 of N interdigitated λ/4 electrodes 48 and 50 extend from the opposed pads 44 and 46 to form an elongate transducer 40. For simplicity of the drawings, only four groups of electrodes are shown in Figure 3. In this case, as shown in Figure 3, two electrodes, such as 48 and 50, equal the N interdigitated λ/4 electrodes in each of the groups 52, 54, 56 and 58. It will be noted that each of the groups 52, 54, 56 and 58 of interdigitated electrodes have a spacing within the group of λ/4 and, for an unweighted transducer, with maximum coupling, the spaces 60, 62 and 64 between adjacent groups of said interdigitated electrodes have a spacing of λ/2. It will also be noted that for an unweighted transducer, with maximum coupling, every alternate λ/2 space, such as space 62, is formed by two adjacent electrodes 66 and 68 extending from a common transducer pad such as pad 46. Such construction causes adjacent groups such as 52 and 54 or 56 and 58 to cancel reflections from each other thus creating a substantially reflectionless transducer 40.

Thus, summarizing, all of the electrodes in the unweighted transducer are λ/4 wide and the gaps or spacing within each group are λ/4 while the spaces between adjacent groups of interdigitated electrodes are spaced λ/2. In addition, in order to maximize the coupling between the electrodes to the transducer acoustic wave, every alternate λ/2 space between unweighted groups is formed by two adjacent electrodes extending from a common transducer pad. If other electrodes are added to change the operation of the transducer, the spacing of the electrodes must stay the same but the electrodes will be coupled to one or the other of the transducer pads as necessary to achieve maximum coupling. Thus, with the transducer shown in Figure 3, electrode reflections are completely cancelled by destructive interference on a local basis. Reflections of each electrode in the transducer are cancelled by the reflections of neighbouring electrode λ/2 (or a multiple distance thereof) away. Thus electrode group 52 of Figure 3 cancels the reflections of the electrodes in group 54 while the electrodes of group 56 cancel the reflections of the electrodes in group 58. The electrodes in other groups (not shown) would operate in a similar manner to cancel the reflections from each other. This means that the transducer output is undistorted and the shape of the input conductance is undistorted. In addition, the device can be constructed to operate at a maximum frequency because of the λ/4 electrode construction.

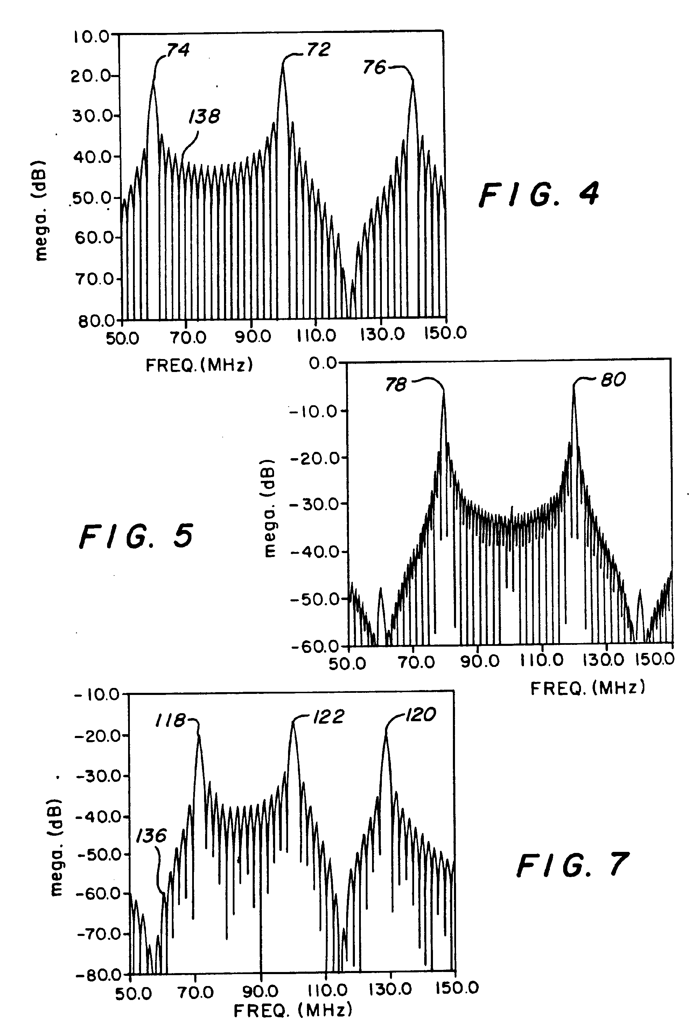

Because of the non-uniform sampling by the non-periodic placement of the electrodes, the transducer 40 has undesired out-of-band spurious "group-type" responses. These are illustrated in Figure 4 which shows the broad band frequency response for a prototype filter formed with structure of the type shown in Figure 3 on a YZ-LiNb0₃ substrate. It will be noted that the group type responses 74 and 76 in Figure 4 are 40% above and below the pass band indicated at 72. This is sufficiently far removed from the pass band for most filtering applications.

Figure 5 illustrates the acoustic reflection coefficient on the transducer 40 of Figure 3 under short circuit conditions. As can be seen, the reflection coefficient is extremely small across the pass band. The greatest reflections occur at points 78 and 80 which are out of the pass band.

Other sampling configurations can be employed if desired. For instance, in Figure 6, there is disclosed schematically a representation of an unweighted transducer 82 with electrode groupings 90, 92, 94 and 96 of three electrodes each. Again, each of the electrodes is constructed with a λ/4 width and are separated by spaces within the group such as space 110 and 112 which are λ/4 in width for maximum coupling. It will be noted that the spaces 104, 106 and 108, which are the spaces between the adjacent groups of the interdigitated electrodes have a spacing of λ/2. Again, in this example the reflections generated by one group of electrodes are cancelled by the reflections generated by an adjacent group of electrodes. For instance, the reflections generated by electrode group 90 are cancelled by the reflections of the electrodes in group 92. In like manner the reflections in electrode group 94 are cancelled by the reflections of electrode group 96. These cancellations occur because, as stated earlier, of the λ/2 spacing, or multiples thereof, between electrodes of one group and the electrodes of an adjacent group and the λ/4 construction of the electrodes and of the spacing between adjacent electrodes within a group.

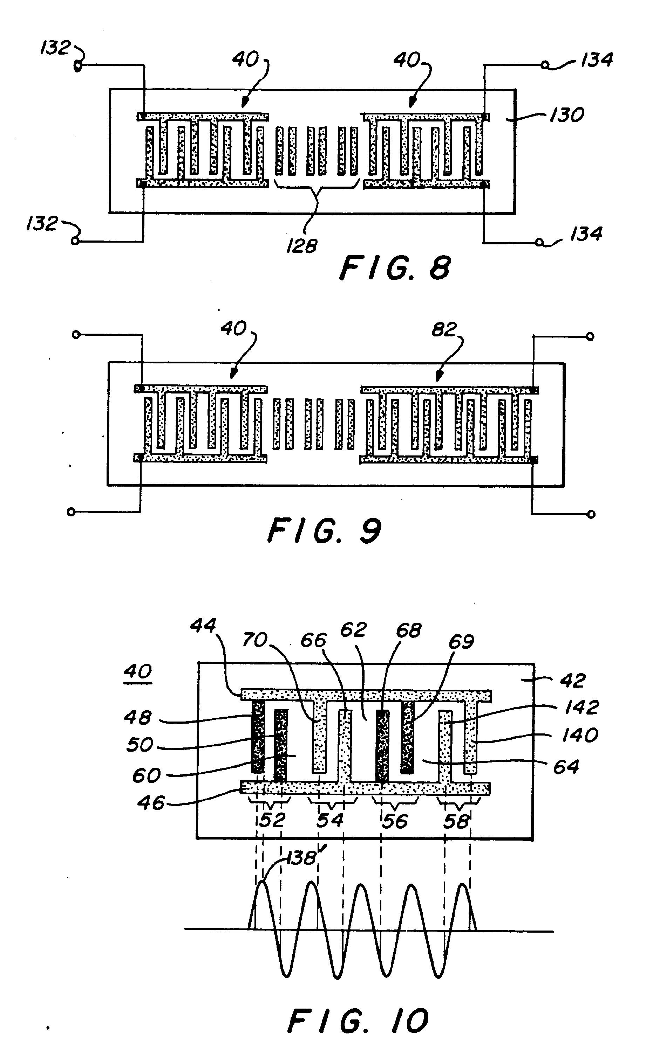

The frequency response for the structure of Figure 6 on a substate of LiNb0₃ is shown in Figure 7. Note that the group type out-of-band response 118 and 120 for this structure are closer to the pass band at point 122 than with the preferred implementation shown in Figure 4. As will be explained hereinafter with relation of Figures 9 and 10, different sampling schemes can be employed with two transducers in a SAW filter configuration or a coupled responator configuration to effectively suppress the out-of-band spurious responses at peaks 118 and 120 in Figure 7 and peaks 74 and 76 in Figure 4.

Figure 8 illustrates a filter which can be constructed of the resonators shown in Figure 3. Thus the two transducer structures 40 are placed on a substrate 130 in spaced relationship with appropriate gratings 128. Thus a filter of conventional construction is utilized with the two novel structures 40. Input terminals are shown at 132 and output terminals at 134.

As stated earlier, one of the ways in which the out-of-hand spurious responses can effectively be suppressed is to couple the transducer in Figure 3 having two electrodes per group to a transducer having a different number of electrodes per group such as the transducer in Figure 6 having three electrodes per group. Such resonator filter structure is shown in Figure 9. When these two structures 40 and 82 communicate with each other, the centre peaks 72 and 122, (in Figure 4 and Figure 7) the pass band frequency and the point of lowest reflections, are at the same frequency and thus the signals pass freely between the transducers 40 and 82. However, the out-of-band spurious responses 74, 118, 76, and 120 all occur at different frequencies and thus it is difficult for the two transducer to effectively couple these signals from one to the other in the out-of-band region since when the spurious response of one transducer is at a peak, for instance 74, the spurious response of the other is at a null, such as at peak 136 in Figure 7. In like manner, when transducer 82 in Figure 6 has a maximum out-of-band spurious response at 118, transducer 40 in Figure 3 has a null as indicated approximately at point 138 in Figure 4. Thus the two transducers do not effectively communicate with each other except at the pass band frequency which, of course, is what is desired.

A further advantage of the transducer of the present invention is that, with an additional second-level metalization, the structure can be made unidirectional. The unidirectional nature of this configuration can be understood by reference to the transduced electric field pattern shown under the transducer 40 in Figure 10. It will be noted that the peak of transduction for each electrode occurs at the edge of the electrode. For instance peak 138′ occurs at the right edge of electrode 48. As is well known in the art, when the centres of transduction are positioned λ/8 or 45° from the effective centre of reflection the introduction of internal reflections will result in unidirectional behaviour, as explained in U.S. Patent No. 4,353,046. Thus in this configuration shown in Figure 10, the locations of the electrodes correspond precisely to those locations at which the introduction of internal reflections will result in unidirectional behaviour. In this structure, unweighted electrodes of one group cancel the reflections of the adjacent group. Thus, in order to introduce the necessary internal reflections for unidirectional behaviour, additional mass loading is added to every alternate pair of electrodes as shown, for example, by electrodes 48 and 50 and electrodes 68 and 69. The reflections introduced by this mass loading will be located at the centre of each mass loaded electrode thus causing the transducer to be unidirectional for the reasons set forth in U.S. Patent No. 4,353,046. It is also extremely easy with this transducer configuration to reverse the sense of unidirectionality. This can be accomplished simply by adding the additional mass loading to the other alternate pairs of electrodes such as electrodes 70 and 66 and 140 and 142 instead of 48 and 50 and 68 and 69 as those shown in Figure 10.

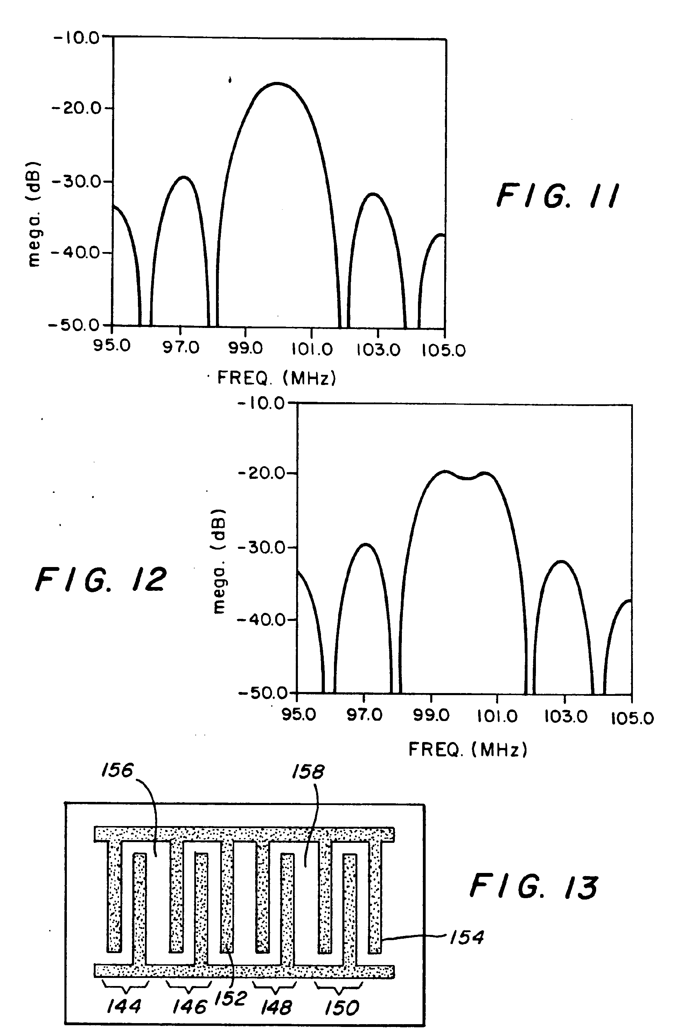

Figure 11 shows the frequency response of the transducer of Figure 10 on the forward acoustic port in an embodiment wherein the transducer is fixed on quartz. For comparison, the frequency response on the reverse acoustic port is shown in Figure 12. Thus the frequency response on the reverse port is approximately 5DB less than that on the forward port. The structure is thus seen to be substantially unidirectional.

Thus, the structures of Figures 8 and 9, can be weighted or mass loaded to cause the transducers to be unidirectional towards each other by mass loading appropriated ones of the alternate groups of electrodes.

Figure 13 illustrates another embodiment of the present invention which is weakly unidirectional in the configuration shown. Thus electrode pair 144 cancels the reflections of electrode pair 146 because of the λ/2 spacing 156. In addition, electrode pair 148 cancels the reflections from electrode pair 150 because of the nλ/2 spacing 158. However, added electrodes 152 and 154 produce reflections which are not cancelled and thus the device is weakly unidirectional.

Thus there has been disclosed a transducer configuration which is an important reflectionless transducer which can be easily made into a unidirectional transducer structure in its own right. It has important advantages over the conventional single phase unidirectional transducer configuration. Since all of the electrodes and gaps are a minimum of λ/4, compared to λ/8 in the conventional configuration, these devices can be fabricated at higher frequencies. They have a symmetric input conductance and an undistorted output. They can be made unidirectional by mass loading alternate electrodes. In addition, λ/4 electrodes have greater reflectivity which is a problem encountered in conventional single-phase unidirectional transducers. These transducers can be expected to find applications whereever a low loss transducer technology is required. They will be very useful for filtering for band widths in the one percent to five percent range. The maximum useful band width is limited only by the maximum internal distributed reflectivity that can be achieved. This will be particularly useful for low loss filter applications at high frequencies such as cellular radio which is in the 800-900 MHz range. At these frequencies, the available alternative low loss technology, such as the three-phase transducer or the split finger transducer, becomes extremely difficult to fabricate. Further these unidirectional transducers can be fabricated on quartz, LiNb0₃ or on any other type of substrate. Also, the number of electrodes, N per group, may be any practical number where N is equal to or greater than 2.

## Claims

1. A substantially reflectionless surface acoustic wave transducer comprising a substrate (42) having at least a surface layer of piezo-electric material on which surface acoustic waves may be propagated, first and second opposed conductive transducer pads (44,46) on the substrate; and a plurality of groups (52,54,56,58) of N interdigitated λ/4 electrodes (48,50) (where N is an integer ≧2) extending from the opposed conductive pads to form an elongate transducer, characterised in that all adjacent ones of the electrodes in each of the groups extend from different ones of the two pads, adjacent electrodes within each group having a spacing of λ/4 and the spaces (60,62,64) between adjacent groups having a spacing of λ/2, or a multiple thereof, such that adjacent groups cancel reflections from one another.

2. A weakly unidirectional surface acoustic wave transducer comprising a substrate (42) having at least a surface layer of piezo-electric material on which surface acoustic waves may be propagated, first and second opposed conductive transducer pads (44,46) on the substrate; and a plurality of groups (52,54,56,58) of N interdigitated λ/4 electrodes (48,50) (where N is an integer ≧2) extending from the opposed conductive pads to form an elongate transducer, with all adjacent ones of the electrodes in each of the groups extending from different ones of the two pads, adjacent electrodes within each group having a spacing of λ/4 and the spaces (60,62,64) between adjacent groups having a spacing of λ/2, or a multiple thereof, and alternate ones (52,56) of the groups of electrodes being mass loaded to provide weak unidirectional wave propagation (Figure 10).

3. A weakly unidirectional surface acoustic wave transducer comprising a substrate (42) having at least a surface layer of piezo-electric material on which surface acoustic waves may be propagated, first and second opposed conductive transducer pads (44,46) on the substrate; and a plurality of alternate groups (144,146) of N and N+1 interdigitated electrodes (where N is an integer ≧2) extending from the opposed conductive pads to form an elongate transducer, with all adjacent ones of the electrodes in each of the groups extending from different ones of the two pads, adjacent electrodes within each group having a spacing of λ/4 and the spaces (60,62,64) between adjacent groups having a spacing of λ/2, or a multiple thereof, such that the (N+1)st electrode(s) provide(s) weak unidirectional wave propagation (Figure 13).

4. A transducer according to claim 1 or claim 2, wherein N = 2 (Figure 3).

5. A transducer according to claims 1 or claim 2, wherein N = 3 (Figure 6).

6. An impedence element comprising electrical input and output leads operatively coupled to a transducer according to any one of the preceding claims.

7. A single port resonator comprising electrical input and output leads operatively coupled to a transducer according to any one of claims 1 to 5.

8. A surface acoustic wave resonator filter of the type having input and output spaced aligned transducers (40,82) and a grating structure (128) interposed between the input and output transducers and being resonant at the same frequency as the input and output transducers, wherein a first one (40) of the transducers is in accordance with claims 4 when dependent on claim 2 and the second one (82) of the transducers is in accordance with claim 5 when dependent on claim 2, the mass loading of alternate ones of the electrode groups of the first transducer causing substantial unidirectional wave propagation in the direction of the second transducer; and the mass loading of alternate ones of the electrode groups of the second transducer causing substantial unidirectional wave propagation in the direction of the first transducer, whereby a filter is obtained with suppression of out-of-band responses.

9. A surface acoustic wave resonator of the type having input and output spaced aligned transducers (40,82); wherein a first one (40) of the transducers is in accordance with claim 4 when dependent on claim 2, and the second one of the transducers is in accordance with claim 5 when dependent on claim 2; the mass loading of alternate ones of the electrode groups of the first transducer causing substantial unidrectional wave propagation in the direction of the second transducer, and the mass loading alternate ones of the electrode groups of the second transducer causing substantial unidirectional wave propagation in the direction of the first transducer, whereby a resonator is obtained with suppression of out-of-band responses.

## Patentansprüche

1. Im wesentlichen reflexionsloser akustischer Oberflächenwellenübertrager, der ein Substrat (42) mit mindestens einer Oberflächenschicht eines piezoelektrischen Materials, auf dem sich akustische Oberflächenwellen fortpflanzen können, erste und zweite, einander gegenüberliegende, leitende Übertragerleitungen (44, 46) auf dem Substrat und mehrere Gruppen (52, 54, 56, 58) von N miteinander verzahnten λ/4-Elektroden (48, 50) umfaßt (wobei N eine ganze Zahl ≧ 2 ist), die sich von den einander gegenüberliegenden Leitungen hinwegerstrecken, um einen langgestreckten Übertrager auszubilden, dadurch **gekennzeichnet**, daß alle der benachbarten Elektroden in jeder der Gruppen sich von verschiedenen der beiden Leitungen hinwegerstrecken, wobei benachbarte Elektroden innerhalb jeder Gruppe einen Abstand von λ/4 und die Lücken (60, 62, 64) zwischen benachbarten Gruppen einen Abstand von λ/2 oder ein Mehrfaches davon besitzen, so daß benachbarte Gruppen ihre gegenseitigen Reflektionen auslöschen.

2. Schwach unidirektionaler akustischer Oberflächenwellenübertrager, der ein Substrat (42) mit mindestens einer Oberflächenschicht eines piezoelektrischen Materials, auf dem sich akustische Oberflächenwellen fortpflanzen können, erste und zweite, einander gegenüberliegende, leitende Übertragerleitungen (44, 46) auf dem Substrat und mehrere Gruppen (52, 54, 56, 58) von N miteinander verzahnten λ/4-Elektroden (48, 50) umfaßt (wobei N eine ganze Zahl ≧ 2 ist), die sich von den einander gegenüberliegenden Leitungen hinwegerstrecken, um einen langgestreckten Übertrager auszubilden, wobei alle der benachbarten Elektroden in jeder der Gruppen sich von verschiedenen der beiden Leitungen hinwegerstrecken, benachbarte Elektroden innerhalb jeder Gruppe einen Abstand von λ/4 und die Lücken (60, 62, 64) zwischen benachbarten Gruppen einen Abstand von λ/2 oder ein Vielfaches davon besitzen, und die Elektrodengruppen abwechselnd (52, 56) mit Masse beladen sind, um für eine schwach unidirektionale Wellenfortpflanzung zu sorgen (Figur 10).

3. Schwach unidirektionaler akustischer Oberflächenwellenübertrager, der ein Substrat (42) mit mindestens einer Oberflächenschicht eines piezoelektrischen Materials, auf dem sich akustische Oberflächenwellen fortpflanzen können, erste und zweite, einander gegenüberliegende, leitende Übertragerleitungen (44, 46) auf dem Substrat und mehrere sich abwechselnde Gruppen (144, 146) von N und N+1 miteinander verzahnten Elektroden umfaßt (wobei N eine ganze Zahl ≧ 2 ist), die sich von den einander gegenüberliegenden Leitungen hinwegerstrecken, um einen langgestreckten Übertrager auszubilden, wobei alle der benachbarten Elektroden in jeder der Gruppen sich von verschiedenen der beiden Leitungen hinwegerstrecken und benachbarte Elektroden innerhalb jeder Gruppe einen Abstand von λ/4 und die Lücken (60, 62, 64) zwischen benachbarten Gruppen einen Abstand von λ/2 oder ein Vielfaches davon besitzen, so daß die (N+1). Elektrode(n) für eine schwach unidirektionale Wellenfortpflanzung sorgt/sorgen (Figur 13).

4. Übertrager nach Anspruch 1 oder Anspruch 2, bei dem N=2 ist (Figur 3).

5. Übertrager nach Anspruch 1 oder Anspruch 2, bei dem N=3 ist (Figur 6).

6. Impedanzelement, das elektrische Eingangs- und Ausgangsleitungen erfaßt, die wirksam mit einem Übertrager nach einem der vorhergehenden Ansprüche gekoppelt sind.

7. Resonator mit einem Anschluß, der elektrische Eingangsund Ausgangsleitungen umfaßt, die wirksam mit einem Übertrager nach einem der Ansprüche 1 bis 5 gekoppelt sind.

8. Akustischer Oberflächenwellen-Resonatorfilter, der beabstandete, ausgerichtete Eingangs- und Ausgangsübertrager (40, 82) und eine zwischen den Eingangs- und Ausgangsübertragern angeordnete Gitterstruktur (128) besitzt und bei derselben Frequenz wie die Eingangs- und Ausgangsübertrager in Resonanz ist, bei dem ein erster (40) der Übertrager gemäß Anspruch 4 ausgebildet ist, wenn dieser von Anspruch 2 abhängt, und der zweite (82) der Übertrager gemäß Anspruch 5 ausgebildet ist, wenn dieser von Anspruch 2 abhängt, wobei die Massebeladung sich abwechselnder Elektrodengruppen des ersten Übertragers eine im wesentlichen unidirektionale Wellenfortpflanzung in der Richtung des zweiten Übertragers verursacht, und wobei die Massebeladung sich abwechselnder Elektrodengruppen des zweiten Übertragers eine im wesentlichen unidirektionale Wellenfortpflanzung in der Richtung des ersten Übertragers verursacht, wodurch man einen Filter mit Unterdrückung der Außerband-Antworten erhält.

9. Akustischer Oberflächenwellenresonator mit beabstandeten, ausgerichteten Eingangs- und Ausgangsübertragern (40, 82), bei dem ein erster (40) der Übertrager gemäß Anspruch 4 ausgebildet ist, wenn dieser von Anspruch 2 abhängt, und der zweite der Übertrager gemäß Anspruch 5 ausgebildet ist, wenn dieser von Anspruch 2 abhängt, wobei die Massebeladung sich abwechselnder Elektrodengruppen des ersten Übertragers eine im wesentlichen unidirektionale Wellenfortpflanzung in der Richtung des zweiten Übertragers verursacht, und wobei die Massebeladung sich abwechselnder Elektrodengruppen des zweiten Übertragers eine im wesentlichen unidirektionale Wellenfortpflanzung in der Richtung des ersten Übertragers verursacht, wodurch man einen Resonator mit Unterdrückung der Außerband-Antworten erhält.

## Revendications

1. Transducteur d'onde acoustique de surface essentiellement sans réflexions, qui comprend un substrat (42) ayant au moins une couche superficielle en matériau piézo-électrique sur laquelle des ondes acoustiques de surface peuvent être propagées, des premières et secondes barrettes conductrices de transducteur (44, 46) opposées, placées sur le substrat et une pluralité de groupes (52, 54, 56, 58) de N électrodes λ/4 (48, 50) entrecroisées (N étant un nombre entier ≧ 2) qui partent des barrettes conductrices opposées pour former un transducteur allongé, caractérisé en ce que toutes les électrodes adjacentes prises dans chacun des groupes partent de l'une différente des deux barrettes, des électrodes adjacentes à l'intérieur de chaque groupe étant espacées de λ/4 et les intervalles (60, 62, 64) entre groupes adjacents étant espacés de λ/2, ou d'un multiple de cette valeur, de telle sorte que des groupes adjacents annulent mutuellement leurs réflexions.

2. Transducteur d'onde acoustique de surface faiblement unidirectionnel qui comprend un substrat (42) ayant au moins une couche superficielle en matériau piézo-électrique sur laquelle des ondes acoustiques de surface peuvent être propagées, des premières et secondes barrettes conductrices de transducteur (44, 46) opposées, placées sur le substrat et une pluralité de groupes (52, 54, 56, 58) de N électrodes λ/4 (48, 50) entrecroisées (N étant un nombre entier ≧ 2) qui partent des barrettes conductrices opposées pour former un transducteur allongé, avec toutes les électrodes adjacentes prises dans chacun des groupes qui partent de l'une différente des deux barrettes, des électrodes adjacentes à l'intérieur de chaque groupe étant espacées de λ/4 et les intervalles (60, 62, 64) entre groupes adjacents étant espacés de λ/2, ou d'un multiple de cette valeur, et des groupes alternés (52, 56) d'électrodes étant mis à la masse pour assurer une propagation faiblement unidirectionnelle de l'onde (Figure 10).

3. Transducteur d'onde acoustique de surface faiblement unidirectionnel qui comprend un substrat (42) ayant au moins une couche superficielle en matériau piézo-électrique sur laquelle des ondes acoustiques de surface peuvent être propagées, des premières et secondes barrettes conductrices de transducteur (44, 46) opposées, placées sur le substrat et une pluralité de groupes alternés (144, 146) faits de N et N+1 électrodes entrecroisées (N étant un nombre entier ≧ 2) qui partent des barrettes conductrices opposées pour former un transducteur allongé, avec toutes les électrodes adjacentes prises dans chacun des groupes qui partent de l'une différente des deux barrettes, des électrodes adjacentes à l'intérieur de chaque groupe étant espacées de λ/4 et les intervalles (60, 62, 64) entre groupes adjacents étant espacés de λ/2, ou d'un multiple de cette valeur, de telle sorte que la ou les (N+1)^{ième(s)} électrode(s) donne(nt) une propagation d'onde faiblement unidirectionnelle (Figure 13).

4. Transducteur selon la revendication 1 ou la revendication 2, dans lequel N = 2 (Figure 3).

5. Transducteur selon la revendication 1 ou la revendication 2, dans lequel N = 3 (Figure 6).

6. Elément impédant qui comprend des conducteurs électriques d'entrée et de sortie branchés de façon opérationnelle à un transducteur conforme à l'une quelconque des précédentes revendications.

7. Résonateur à accès unique qui comprend des conducteurs électriques d'entrée et de sortie branchés de façon opérationnelle à un transducteur conforme à l'une quelconque des revendications 1 à 5.

8. Filtre résonateur d'onde acoustique de surface du type qui comprend des transducteurs (40, 82) alignés et espacés d'entrée et de sortie et une structure (128) formant réseau de diffraction interposée entre les transducteurs d'entrée et de sortie et résonant à la même fréquence que les transducteurs d'entrée et de sortie, dans lequel un premier (40) des transducteurs est conforme à la revendication 4 lorsqu'elle dépend de la revendication 2 et le second (82) des transducteurs est conforme à la revendication 5 lorsqu'elle dépend de la revendication 2, la mise à la masse des groupes alternés d'électrodes du premier transducteur provoquant une propagation essentiellement unidirectionnelle de l'onde dans la direction du second transducteur et la mise à la masse des groupes alternés d'électrodes du second transducteur provoquant une propagation essentiellement unidirectionnelle de l'onde dans la direction du premier transducteur, ce qui fait que l'on obtient un filtre avec une suppression des réponses hors bande.

9. Résonateur d'onde acoustique de surface du type qui comprend des transducteurs (40, 82) alignés et espacés d'entrée et de sortie, dans lequel un premier (40) des transducteurs est conforme à la revendication 4 lorsqu'elle dépend de la revendication 2 et le second des transducteurs est conforme à la revendication 5 lorsqu'elle dépend de la revendication 2, la mise à la masse des groupes alternés d'électrodes du premier transducteur provoquant une propagation essentiellement unidirectionnelle de l'onde dans la direction du second transducteur et la mise à la masse des groupes alternés d'électrodes du second transducteur provoquant une propagation essentiellement unidirectionnelle de l'onde dans la direction du premier transducteur, ce qui fait que l'on obtient un résonateur avec une suppression des réponses hors bande.
